# FASCICULE DE BREVET EUROPEEN

(11) **EP 3 538 683 B1**
(45) Date de publication et mention de la délivrance du brevet: **17.08.2022**
(21) Numéro de dépôt: 17797610.7
(22) Date de dépôt: 07.11.2017
(51) Int. Cl.: C23C 14/04, G02C 7/02, C23C 14/50

(54) **INSTALLATION DE DÉPÔT PAR ÉVAPORATION D'UN REVÊTEMENT SUR DES ARTICLES OPTIQUES**
VORRICHTUNG ZUR AUFDAMPFUNG VON EINER BESCHICHTUNG AUF OPTISCHE ARTIKEL
APPARATUS FOR VAPOR DEPOSITION OF A COATING ON OPTICAL ARTICLES

(30) Priorité: 10.11.2016 FR 1660904
(43) Date de publication de la demande: 18.09.2019
(73) Titulaire: BNL Eurolens, 01200 Montanges (FR)
(72) Inventeur: ESTEVEZ RODRIGUEZ, Vicente, 01200 Bellegarde sur Valserine (FR)
(74) Mandataire: Croonenbroek, Thomas Jakob
(86) Numéro de dépôt international: PCT/EP2017/078471
(87) Numéro de publication internationale: WO 2018/087090

(56) Documents cités:
- DE-A1- 10 234 855
- US-A1- 2009 090 301
- US-A1- 2013 228 121
- US-B1- 6 447 653

## Description

La présente invention concerne une installation de dépôt par évaporation d'un revêtement sur des articles optiques et plus spécifiquement un cache de répartition.

Par article optique, on entend en particulier un insert, une plaquette, un verre semi-fini, une lentille, correctrice ou non, qui peut être utilisée comme un verre de lunette, par exemple pour des lunettes, en particulier des lunettes de soleil ou des masques ou analogues. Cet article est notamment réalisé en verre ou en matière plastique. L'article optique peut être réalisé en une ou plusieurs couches formant un ensemble.

De façon générale, un article optique, comme par exemple une lentille optique, est issu d'un procédé complexe de fabrication qui comprend par exemple la fabrication d'un insert ou d'une plaquette (également appelé « wafer » en anglais »), par exemple en matière plastique par un procédé d'injection dans un moule.

Puis, pour conférer à l'insert (et donc à la lentille finale devant être disposées devant par exemple l'œil humain) des caractéristiques supplémentaires, on applique par exemple un ou plusieurs traitements de surface.

Ces traitements de surface peuvent être un traitement antireflet et/ou un traitement de durcissement, et/ou un traitement d'application d'une couleur.

Pour ce faire, il est connu de réaliser un tel traitement de surface par dépôt d'un revêtement formé d'au moins une couche de matériau par un procédé par évaporation, et, plus précisément, par évaporation sous vide.

Pour des raisons économiques et pour un gain de temps, un grand nombre d'articles optiques sont traités en même temps, et l'enceinte de traitement mise en œuvre pour ce faire comporte, intérieurement un support qui, monté rotatif, présente, répartis autour de son axe de rotation, une pluralité d'emplacements propres à recevoir chacun un article optique à traiter, et qui, en pratique, est globalement en forme de calotte sphérique ou de dôme.

En dessous de ce dôme rotatif est disposée sur l'axe de rotation une source émettrice, à partir de laquelle le matériau à déposer est évaporé selon un cône d'évaporation.

En pratique, cette source émettrice est par exemple constituée par un support sur lequel est disposé le matériau à évaporer, par exemple un creuset ou une platine, et, pour son évaporation, le matériau est par exemple soumis à un échauffement par effet Joule, à un bombardement électronique, ou à un effet de pulvérisation cathodique. Le cône d'évaporation peut être considéré comme l'enveloppe des molécules envoyées en direction des articles optique à traiter.

Dans tous les cas, l'une des difficultés à surmonter tient à ce que, pour des raisons évidentes, notamment liées au cône d'évaporation, il importe que le ou les dépôts effectués se fassent de manière uniforme sur chacun des articles optiques indépendamment de leur emplacement dans le dôme rotatif et en particulier indépendamment de l'éloignement de l'axe de rotation du dôme afin qu'ils soient identiques pour l'ensemble de ceux-ci.

Or, le cône d'évaporation d'un matériau n'est en pratique pas isotrope. En effet, la densité du matériau est généralement plus importante au centre du cône que sur les bords latéraux.

En effet, en coupe transversale, c'est-à-dire selon une direction perpendiculaire à l'axe de rotation, la densité des molécules émises n'est pas homogène et la densité est plus importe proche de l'axe de rotation et moins importante quand on s'éloigne de l'axe de rotation.

Une première réponse à ce problème est la forme en calotte du support rotatif ou dôme.

Toutefois, cette mesure n'est pas suffisante et pour minimiser davantage cette différence, qui peut notamment conduire à des disparités intempestives de caractéristiques, et, en particulier, de teintes, entre les articles optiques ainsi traités, il est connu d'interposer, entre la source émettrice et le support rotatif portant les différents articles optiques à traiter, un cache de répartition de configuration appropriée.

Cela est le cas, par exemple, dans les documents FR2775298, US4 380 212 et US4 449 478 ou encore EP0 928 977, ou encore dans les documents US 2013/228121, US 2009/090301, ou US 6447653.

Déterminée généralement expérimentalement, la configuration du cache de répartition ainsi mis en œuvre est telle que l'envergure de ce cache de répartition est par exemple plus importante à proximité de l'axe de rotation du support rotatif qu'à distance de cet axe de rotation.

Ainsi, le dépôt d'une couche de matériau sur les divers articles optiques traités peut sensiblement se faire suivant la même épaisseur pour l'ensemble de ceux-ci.

Ceci permet que les résultats soient globalement satisfaisants pour des articles optiques présentant un faible rayon de courbure. Cependant, on a constaté des défauts de dépôt pour des articles optiques de plus fortes courbure.

En effet, le centre de l'article optique est à une distance différente, de la source par rapport au bord de l'article optique. La distance du centre peut être plus proche ou plus lointain de la source que le bord selon que le revêtement soit appliqué sur une surface convexe ou respectivement concave de l'article optique.

Il en résulte un défaut d'uniformité de dépôt et les épaisseurs du dépôt effectué du traitement de surface sont donc différentes sur les bords des articles optiques, par exemple moins importantes. Cette non-uniformité peut réduire les performances de l'antireflet ainsi fabriqué introduire une variation de la répartition d'une couleur qui n'apparaît alors plus uniforme, ou introduire une irisation sous la forme de reflets en bandes de couleur alternées selon certains angles d'incidence.

En effet, pour un multi-couches fonctionnel comme par exemple un traitement antireflet ou un filtre interférentiel, les défauts de non uniformité des différentes couches s'additionnent et impactent la performance d'un tel multi-couches fonctionnel, notamment sur les bords.

Les caches connus de l'état de la technique ne permettent pas de résoudre cette problématique et n'adressent principalement qu'une variation d'épaisseur d'un verre optique à l'autre, mais pas un défaut d'uniformité au niveau d'un même article optique.

L'invention a donc pour objectif de proposer un cache de répartition pour le contrôle du dépôt par évaporation d'un revêtement sur un article optique qui permette de mieux uniformiser, au moins sur une portion en bande allant d'un bord périphérique vers un bord opposé en passant par le centre, un traitement de surface pour un article optique ayant une courbure ou sphéricité importante, et en particulier pour uniformiser, à moindre coûts, les traitements de surfaces déposés sur une multiplicité d'articles optiques.

À cet effet, l'invention a pour objet une installation de dépôt par évaporation d'un revêtement sur des articles optiques, comportant
- une source émettrice de molécules d'un matériau à déposer sur les articles optiques, les molécules étant émises selon un cône d'évaporation,
- un support rotatif d'articles optiques comportant des logements individuels destinés à recevoir les articles optiques et réalisant en cours de rotation du support rotatif des tours de révolution, et
- un cache de répartition disposé sur le trajet d'une partie des molécules émises par ladite source émettrice en direction du support rotatif d'articles optiques,
dans laquelle le cache de répartition est aménagé avec au moins un bras disposé de manière à masquer une zone partielle d'un logement individuel sur une partie du tour de révolution, cette zone partielle masquée comprenant le centre du logement individuel.

Grâce à ces propriétés, lorsque le support est en rotation grâce au cache interposé, des portions périphériques des articles optiques installés dans les logements restent exposées à la source émettrice de matériau alors que la portion du centre est cachée et ne peut pas recevoir les molécules du matériau à déposer.

Le cache de répartition selon l'invention peut présenter une ou plusieurs des caractéristiques suivantes

Selon un aspect, des logements individuels d'articles optiques sont disposés en pistes concentriques et le au moins un bras est disposé de façon centrée en face de la piste concentrique.

Le au moins un bras est notamment courbe en s'étendant le long d'une piste associée.

La largeur du bras perpendiculaire à la piste associée peut être configurée de manière que l'empreinte projetée du bras sur les articles optiques de la piste associée possède une largeur perpendiculaire à la piste associée qui est inférieure à la largeur des articles optiques quand ceux-ci sont portés par le support rotatif de sorte que ledit bras empêche le dépôt de molécules dans une portion centrale des articles optiques et permette le dépôt de molécules dans deux portions latérales des articles optiques disposées de part et d'autre par rapport à la piste associée.

La largeur du bras s'étend selon une direction perpendiculaire à la piste et est notamment inférieure à la largeur des articles optiques destinés à être portés par le support rotatif.

On prévoit par exemple que le cache comporte un bras pour chaque piste du support rotatif.

La largeur perpendiculaire à la piste associée de l'empreinte projetée du bras sur les articles optiques de la piste associée est par exemple comprise entre 60% et 95%, notamment comprise entre 80% et 90% et plus particulièrement 85% de la largeur des articles optiques portés par le support rotatif.

Chaque bras (34) possède par exemple une extrémité arrondie.

Dans ce cas, le rayon de courbure des extrémités arrondies correspond par exemple au rayon de courbure de l'article optique devant recevoir le revêtement.

Le cache peut comporter une portion centrale dont la forme est configurée pour compenser une inhomogénéité du cône d'évaporation entre les différentes pistes de logements d'articles optiques.

L'installation peut comprendre pour chaque piste de logements un premier et un second bras prolongeant la portion centrale symétriquement de part et d'autre de la portion centrale.

La portion centrale peut présenter une forme elliptique ou trapézoïdale.

La longueur des bras augmente par exemple avec l'éloignement des pistes associées concentriques par rapport à l'axe de rotation du support rotatif.

La longueur des paires de bras courbes, en tenant compte d'une portion centrale si celle-ci est présente, couvre angulairement un secteur de cercle compris en particulier entre 60° et 160°, notamment entre 80° et 140°.

Les extrémités des bras peuvent s'inscrire dans une forme correspondant au tracé de la portion centrale.

Le support rotatif possède notamment une forme concave de sorte que les logements d'articles optiques sont disposés à égale distance de la source émettrice.

D'autres caractéristiques et avantages de l'invention apparaîtront plus clairement à la lecture de la description suivante, donnée à titre d'exemple illustratif et non limitatif, et aux dessins annexés montrant :
- la figure 1 est une vue en perspective d'un article optique à traiter,
- la figure 2 est un schéma simplifié de côté, partiellement en coupe transversale d'une enceinte de traitement qui est susceptible d'être mise en œuvre pour le traitement d'articles optiques,
- la figure 3 est une vue schématique par en dessous d'un support rotatif d'articles optiques et d'un cache de répartition pour le contrôle du dépôt,
- la figure 4 est un schéma simplifié montrant un article optique caché par une partie de cache,
- la figure 5 est un schéma simplifié montrant une pluralité d'articles optiques avec une portion de cache,
- la figure 6 est un schéma similaire à celle de la figure 4 d'un article optique ayant subi un traitement, et

Sur toutes les figures, les éléments identiques portent les mêmes numéros de référence. Une référence sous forme de numéro désigne un élément en général ou tous les éléments identiques. Quand le numéro de référence de l'élément est suivi d'une lettre avec ou sans prime, on désigne un élément particulier qui est distinct d'un élément ayant le même numéro de référence mais qui est suivi d'une lettre différente avec ou sans prime.

On va maintenant décrire un exemple d'un mode de réalisation en référence aux figures.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

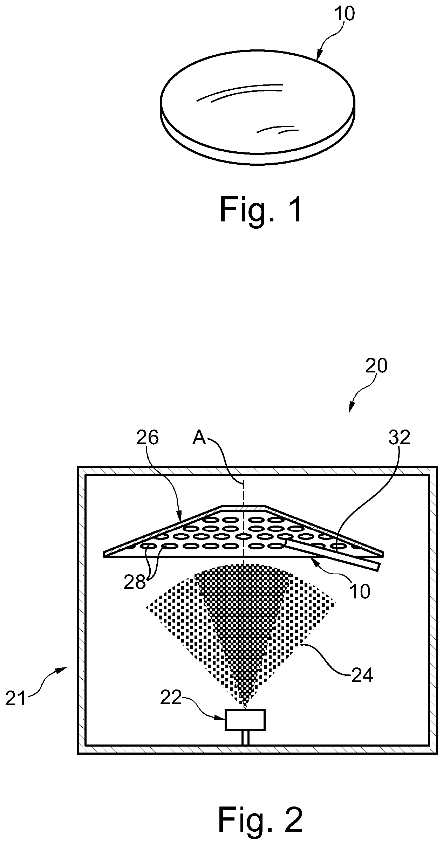

La figure 1 montre un article optique 10 sur lequel un quelconque traitement doit être appliqué.

Cet article optique 10 peut être préférentiellement un article ophtalmique, et en particulier, un insert ou palet de contour, une plaquette, un verre semi-fini, une lentille, correctrice ou non, qui peut être utilisée comme un verre de lunette, par exemple pour des lunettes, en particulier des lunettes de soleil ou des masques ou analogues. Cet article est notamment réalisé en verre minéral ou en matière plastique. L'article optique 10 peut être réalisé en une ou plusieurs couches formant un ensemble.

Le traitement à appliquer sur l'article optique 10 peut être un traitement antireflet et/ou un traitement de durcissement, et/ou un traitement d'application d'une couleur.

La figure 2 montre de façon schématique une installation 20 de dépôt par évaporation d'un revêtement sur un ensemble d'articles optiques 10.

Cette installation 20 comprend une enceinte de traitement 21 et une source 22 émettrice de molécules d'un matériau à déposer sur les articles optiques 10 selon un cône d'évaporation 24.

L'enceinte de traitement 21 peut être fermée hermétiquement et est reliée à une unité de vide (non représentée), par exemple une pompe à vide, pour baisser la pression à l'intérieur de l'enceinte de traitement 21 à une pression adaptée pour le traitement à appliquer, typiquement par exemple de l'ordre de 3.10⁻⁵ mbar.

La source émettrice 22 est par exemple constituée par un support sur lequel est disposé le matériau à évaporer, par exemple un creuset ou une platine, et, pour son évaporation, le matériau est par exemple soumis à un échauffement par effet Joule, à un bombardement électronique, ou à un effet de pulvérisation cathodique.

Le cône d'évaporation 24 n'est pas uniforme et possède dans le centre une densité de molécules évaporées plus importante que sur la périphérie ce qui est indiqué sur la figure 2 par une couleur grise du cône d'évaporation 24 plus foncée au niveau du centre par rapport à la périphérie. Bien entendu, la densité diminue en réalité progressivement depuis le centre vers la périphérie.

Au-dessus de la source émettrice 22 est disposé un support rotatif 26 des articles optiques 10.

A cet effet, le support rotatif 26 comporte des logements individuels 28 des articles optiques 10.

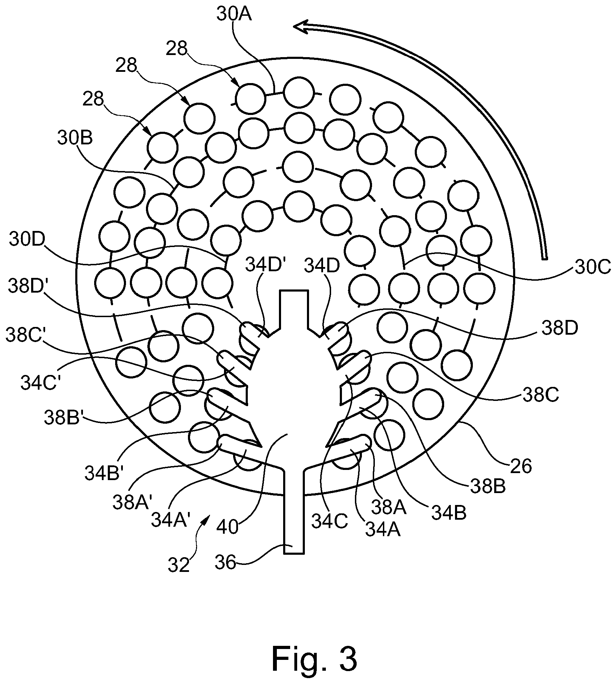

Comme on peut mieux le voir sur la figure 3 montrant une vue par en-dessous du support rotatif 26, les logements individuels 28 sont disposés par exemple sur des pistes concentriques 30 matérialisées sur la figure 3 par des cercles en traits.

Dans le présent exemple, le support rotatif 26 comporte quatre pistes concentriques référencées individuellement 30A, 30B, 30C et 30D avec des logements individuels 28.

Bien entendu, on peut prévoir plus ou moins de pistes concentriques 30 en fonction de la taille de l'installation 20 et en particulier de l'enceinte de traitement 21.

Par ailleurs, sur le support rotatif 26, les pistes concentriques ne sont généralement pas matérialisées. Une piste 30 est par exemple définie par l'ensemble des logements individuels 28 disposés à la même distance du centre du support rotatif 26.

On comprend qu'en rotation du support 26, chacun des logements individuels 28 réalise des tours de révolution.

Le support rotatif 26 possède par exemple une forme concave ou plus spécifiquement en forme de calotte sphérique de sorte que les logements individuels 28 des articles optiques 10 sont disposés à égale distance de la source émettrice 22.

Le support rotatif 26 peut tourner autour d'un axe A qui correspond à l'axe de symétrie du support rotatif et passe par le centre de celui-ci.

L'installation 20 comporte de plus un cache 32 de répartition pour le contrôle du dépôt par évaporation d'un revêtement sur des articles optiques 10. Ce cache 32 est disposé sur le trajet d'une partie des molécules émises par la source émettrice 22 en direction du support rotatif 26 des articles optiques 10.

Comme la figure 3 peut être assimilée à une vue du support rotatif 26 depuis la source 22, on voit que le cache 32 s'interpose pour une partie des molécules émises par la source 22.

Plus précisément, le cache 32 comporte au moins un bras 34, dans le présent cas huit bras individuellement référencés individuellement 34A, 34A', 34B, 34B', 34C, 34C' et 34D, 34D'. Dans ce mode de réalisation particulier, les bras ont une forme générale courbe.

Ces bras courbes 34 s'étendent chacun le long d'une piste associée 30 et sont disposés de façon centrée en face de celle-ci.

Ainsi, les bras courbes 34A, 34A' sont associés à la piste 30A, les bras courbes 34B, 34B' à la piste 30B, les bras courbes 34C, 34C' à la piste 30C et les bras courbes 34D, 34D' à la piste 30D.

Le cache 32 comporte donc deux bras courbes 34 pour chaque piste 30 du support rotatif 26 qui sont disposés symétriquement par rapport à un axe radial de maintien 36 (voir figure 3).

Le rayon de courbure de chaque bras 34 suit celui de la piste associée 30.

La largeur de chaque bras courbe 34 perpendiculaire à la piste associée 30 est configurée de manière que l'empreinte projetée du bras courbe 34 sur les logements individuels 28 et donc sur les articles optiques 10 maintenus dans ces logements individuels 28 de la piste associée 30 possède une largeur perpendiculaire à la piste associée 30 qui est inférieure à la largeur des articles optiques 10 et des logements individuels 28 portés par le support rotatif 26.

L'empreinte projetée peut être assimilée à l'ombre qui serait portée sur le support rotatif 26 par le cache 32 si la source émettrice 22 était une source de lumière. On comprend aisément que si on rapprochait le cache 32 de la source émettrice 22, du fait du cône d'émission 24, il faudrait réduire la taille du cache 32 pour obtenir les mêmes effets.

Pour être le plus précis possible dans le dépôt des revêtements, on essaie de placer le cache 32 le plus près possible du support rotatif 26, typiquement à une dizaine de cm.

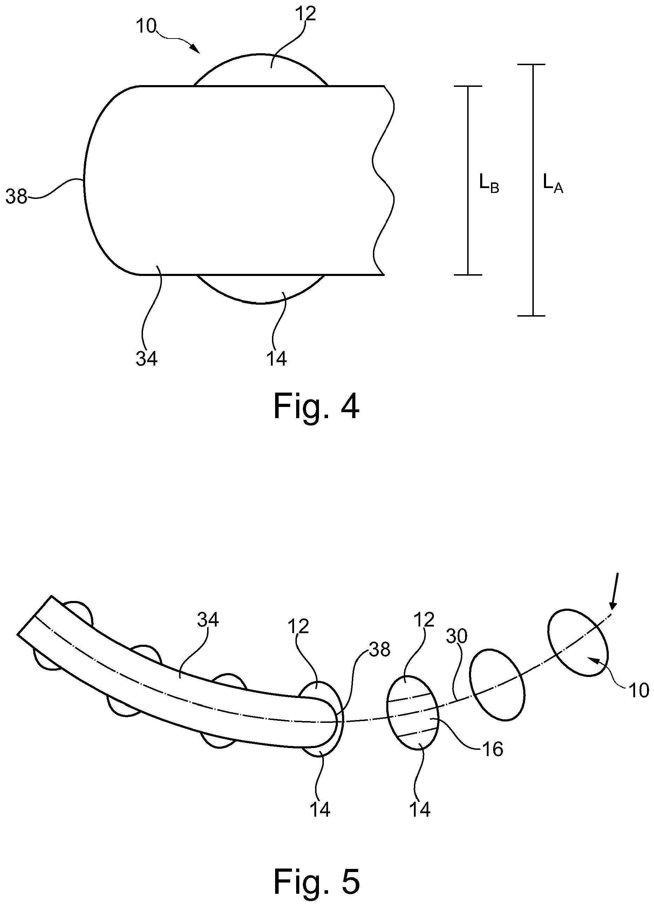

Ceci est bien visible sur la figure 3, mais illustré plus en détail sur les figures 4 et 5.

En effet, les figures 4 et 5 montrent de façon schématique une vue du bras courbe 34 depuis la source émettrice 22.

Alors que sur la figure 3 sont montrés les logements individuels 28, et sur les figures 4 et 5 est représenté un article optique 10. Le contour de l'article optique 10 des figures 4 et 5 est sensiblement le même que le contour de chaque logement individuel 28 pour pouvoir maintenir ces articles optiques 10. Ainsi, les figures 4 et 5 peuvent également s'interpréter par rapport aux logements individuels 28 des articles optiques 10.

Lorsque par la rotation du support rotatif 26, l'article optique 10 dans son logement individuel 28 passe derrière un bras courbe 34 du cache 32, seules des portions latérales ou des bords 12 et 14 sont exposées aux molécules émises par la source émettrice 22.

Ainsi, le ou les bras courbes 34 empêchent le dépôt de molécules dans une zone partielle 16 comprenant le centre du logement individuel 28. Cette zone partielle 16 correspond dans le cas présent à une portion centrale (voir figure 5) des articles optiques 10 et permettent le dépôt de molécules dans les deux portions latérales 12 et 14 des articles optiques 10, ces portions latérales 12 et 14 étant disposées de part et d'autre par rapport à la piste 30 associée. En effet, le centre de l'article optique 10 est à une distance différente de la source émettrice 22 par rapport au bord de l'article optique 10. Dans le cas d'un article optique 10 ayant une courbure ou sphéricité importante, le centre de l'article optique 10 est plus proche de la source émettrice 22 que les bords périphériques. Ainsi, sur un tour de révolution, l'article optique 10 recevrait plus de molécules qui se déposent dans sa partie centrale que sur les bords périphériques. Ceci est donc corrigé par le ou les bras courbes 34 car quand l'article optique 10 est caché par le ou les bras courbes 34, le centre ne reçoit pas de molécules tandis que les bords périphériques en reçoivent toujours. Ainsi, sur un tour de révolution, lorsqu'il n'y a pas de cache devant l'article optique 10, des molécules se déposent sur l'ensemble de l'article optique 10, mais avec une densité plus importante au centre de celui-ci, la zone partielle 16 comprenant le centre du logement individuel 28 (plus proche de la source émettrice 22), que les portions latérales 12 et 14. Lorsque l'article optique 10 est caché par le ou les bras courbes 34, des molécules se déposent uniquement sur les parties latérales 12 et 14 et comblent donc le déficit de molécules déposées par rapport à la zone partielle 16 comprenant le centre de l'article optique 10.

La présence de ce ou ces bras 34 permet de pallier l'écart de distance entre le centre et les bords de l'article optique 10 entraînant un gradient de densité de molécules déposées et permettant ainsi d'assurer une meilleure uniformité du dépôt du revêtement sur l'ensemble de l'article optique 10 ayant une courbure ou une sphéricité importante.

On comprend donc que le cache de répartition 32 est aménagé avec au moins un bras 34 disposé de manière à masquer une zone partielle 16 d'un logement individuel 28 sur une partie du tour de révolution, cette zone partielle 16 masquée comprenant le centre du logement individuel 28.

La largueur L_{B} des bras courbes 34 selon une direction perpendiculaire à la piste 30 est inférieure à la largeur L_{A} des articles optiques 10 destinés à être portés par le support rotatif 26. La largeur L_{A} des articles optiques est mesurée radialement par rapport au centre du support rotatif 26.

Plus spécifiquement, la largeur L_{B} perpendiculaire à la piste associée 30 de l'empreinte projetée du bras courbe 34 sur les articles optiques de la piste associée 30 est comprise entre 60% et 95%, notamment comprise entre 80% et 90% et plus particulièrement d'environ 85% de la largeur L_{A} des articles optiques portés par le support rotatif.

La longueur des paires de bras courbes 34, en tenant compte d'une partie centrale du cache, couvre angulairement un secteur de cercle compris entre 60° et 160°, notamment entre 80° et 140°. Ainsi, lors d'une rotation du support mobile 26, en tenant compte d'une largeur centrale du cache, la partie centrale 16 de l'article optique 10 est seulement exposée aux molécules émises par la source émettrice 22 sur une course angulaire comprise entre 200° et 300°, notamment entre 220° et 280°. Il en résulte aussi que la longueur des bras courbes 34 augmente avec l'éloignement des pistes 30 associées concentriques par rapport à l'axe de rotation A du support rotatif 26.

Dans cette même configuration, les portions latérales 12 et 16 de l'article optique 10 sont exposées aux molécules émises par la source émettrice 22 sur une course angulaire supérieure à comprise entre 250° et 350°, par exemple entre 280° et 350°, par exemple environ 340°.

Selon un mode de réalisation non représenté, le cache 32 peut comporter un unique bras 34 par piste 30 ou deux bras par piste 30. La longueur cumulée du ou des bras 34 d'une piste 30 est avantageusement choisie en fonction d'une différence de hauteur entre le bord et le centre d'un article optique 10 prévu pour être placé dans une des logements individuels 28. En particulier, ladite longueur peut être choisie de façon à couvrir, pour une piste 30, un secteur de cercle choisi en fonction de ladite hauteur. Notamment, ladite hauteur peut être une hauteur moyenne ou médiane des articles optiques 10 destinés à être traités dans ladite installation 20.

De façon plus précise, ladite longueur peut être choisie en fonction de l'impact de la différence de hauteur sur la différence de densité de flux de matière à déposer arrivant respectivement au bord et au centre de l'article optique 10.

Pour encore mieux uniformiser le dépôt, les extrémités 38 (38A, 38A', 38B, 38B', 38C, 38C' et 38D, 38D') des bras courbes 34 possèdent une forme arrondie, dont le rayon de courbure des extrémités arrondies correspond au rayon de courbure de l'article optique 10 devant recevoir le revêtement.

Alors que les bras courbes 34 permettent de mieux homogénéiser le dépôt sur la surface des articles optiques 10 du fait de la courbure ou convexité de ces articles 10, le cache 32 comporte en outre une portion centrale 40 de forme générale, ici en ellipse, configurée pour compenser une inhomogénéité du cône d'évaporation 24 entre les différentes pistes 30 de logements 28 d'articles optiques 10.

Alternativement cette portion centrale peut être absente, ou être sous la forme d'un triangle, d'un losange, d'un trapèze ou de toute autre forme appropriée.

Cette portion centrale 40 est fixée de manière centrale sur l'axe de maintien radial 36.

Comme on le voit sur la figure 3, le cache 32 comporte donc la partie centrale 40 et pour chaque piste 30A, 30B, 30C et 30D de logements un premier 34A, 34B, 34C, et 34D et un second 34A', 34B', 34C' et 34D' bras courbe prolongeant la portion centrale 40 symétriquement par rapport au grand axe d'ellipse disposé de façon radiale par rapport à l'axe de rotation A du support rotatif 26.

Selon une variante non représentée, on peut aussi utiliser deux caches de répartition distincts, un premier cache de répartition avec les bras courbes pour compenser la courbure des articles optiques 10 et un second cache de répartition de forme calibrée pour compenser l'inhomogénéité du cône d'émission 24, disposé par exemple dans un autre secteur du support rotatif 26, en particulier en vis-à-vis.

Enfin, dans un mode de réalisation les extrémités 38 arrondies des bras courbes 34 s'inscrivent dans une forme de semi-ellipse correspondant au tracé de la portion centrale 40 en forme d'ellipse. C'est-à-dire, si on reliait par une courbe imaginaire les extrémités 38A, 38B, 38C, et 38D, on obtient une forme de semi-ellipse qui est sensiblement identique à la forme en ellipse de la portion centrale 40 du même côté de l'axe de maintien 36 mais seulement décalé angulairement. De même, si on reliait par une courbe imaginaire les extrémités 38A', 38B', 38C', et 38D,' on obtient une forme de semi-ellipse qui est sensiblement identique à la forme en ellipse de la portion centrale 40 du même côté de l'axe de maintien 36 mais seulement décalé angulairement.

Une telle forme de semi-ellipse est conçue pour compenser une variation radiale de vitesse de dépôt de matière sur le support rotatif 26, pouvant être due à un écart de la forme du support rotatif 26 par rapport à une portion de sphère centrée sur la source émettrice 22 ou pouvant être dus à une inhomogénéité radiale de distribution de la matière émise par ladite source émettrice.

Dans un autre mode de réalisation, les extrémités 38 arrondies des bras courbes 34 s'inscrivent dans une telle forme de semi-ellipse sans pour autant que la portion centrale 40 ait une forme en ellipse.

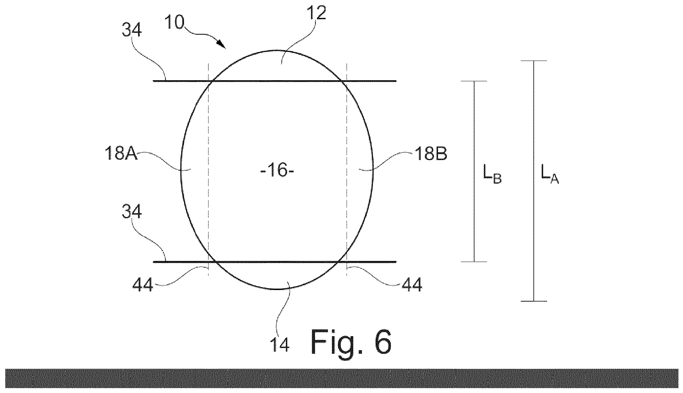

La figure 6 montre un schéma similaire à la figure 4 d'un article optique 10 sur lequel un revêtement a été appliqué comme expliqué ci-dessus. On comprend donc aussi que le revêtement a pu être homogénéisé dans les portions latérales 12 et 14 et centrale 16.

Cependant, dans les portions 18A et 18B, l'homogénéisation du revêtement appliqué est moins bonne que pour les portions 12 et 14 par rapport à la portion centrale 16.

En fonction des exigences souhaitées, on peut couper l'article optique 10 selon les lignes en traits 44 pour obtenir par exemple une lentille ou un verre optique de forme générale rectangulaire.

Ainsi, l'installation selon l'invention permet de déposer de façon très homogène des revêtements sur un article optique 10, au moins selon une bande perpendiculaire à la position de l'article 10 dans le support rotatif 26 grâce au cache 32 avec des bras courbes 34 afin de compenser en particulier l'écart de répartition du revêtement qui est dû à la courbure / sphéricité de l'article optique 10.

## Revendications

1. Installation (20) de dépôt par évaporation d'un revêtement sur des articles optiques (10), comportant
- une source émettrice (22) de molécules d'un matériau à déposer sur les articles optiques (10), les molécules étant émises selon un cône d'évaporation,
- un support rotatif (26) d'articles optiques (10) comportant des logements individuels (28) destinés à recevoir les articles optiques (10) et réalisant en cours de rotation du support rotatif (26) des tours de révolution, les logements individuels (28) d'articles optiques (10) étant disposés en pistes concentriques (30), et
- un cache de répartition (32) disposé sur le trajet d'une partie des molécules émises par ladite source émettrice (22) en direction du support rotatif (26) d'articles optiques (10),
dans laquelle le cache de répartition (32) est aménagé avec au moins un bras courbe (34) s'étendant le long d'une piste (30) associée et disposé de manière à masquer une zone partielle (16) d'un logement individuel (28) sur une partie du tour de révolution, cette zone partielle (16) masquée comprenant le centre du logement individuel (28), le au moins un bras courbe (34) étant disposé de façon centrée en face de la piste concentrique (30) et la largeur de chaque bras courbe (34) perpendiculaire à la piste associée (30) est configurée de manière que l'empreinte projetée du bras courbe (34) sur les logements individuels (28) de la piste associée (30) possède une largeur perpendiculaire à la piste associée (30) qui est inférieure à la largeur des logements individuels (28)

2. Installation selon la revendication 1, dans laquelle le cache (32) comporte un bras (34) pour chaque piste (30) du support rotatif (26).

3. Installation selon l'une quelconque des revendications 1 à 2, dans laquelle la largeur (L_{B}) perpendiculaire à la piste associée (30) de l'empreinte projetée du bras (34) sur les articles optiques (10) de la piste associée (30) est comprise entre 60% et 95%, notamment comprise entre 80% et 90% et plus particulièrement 85% de la largeur des articles optiques (10) portés par le support rotatif (26).

4. Installation selon l'une quelconque des revendications 1 à 3, dans laquelle chaque bras (34) possède une extrémité arrondie (38).

5. Installation selon la revendication 4, dans laquelle le rayon de courbure des extrémités arrondies (38) correspond au rayon de courbure de l'article optique (10) devant recevoir le revêtement.

6. Installation selon l'une quelconque des revendications 1 à 5, dans laquelle le cache (32) comporte une portion centrale (40) configurée pour compenser une inhomogénéité du cône d'évaporation (24) entre les différentes pistes (30) de logements (28) d'articles optiques.

7. Installation selon la revendication 6, dans laquelle elle comprend pour chaque piste (30) de logements (28) un premier et un second bras (34) prolongeant la portion centrale (40) symétriquement de part et d'autre de la portion centrale (40).

8. Installation selon la revendication 6 ou 7, dans laquelle la portion centrale (40) présente une forme elliptique ou trapézoïdale.

9. Installation selon l'une quelconque des revendications 1 à 8, dans laquelle la longueur des bras (34) augmente avec l'éloignement des pistes associées (30) concentriques par rapport à l'axe de rotation (A) du support rotatif (26).

10. Installation selon la revendication 6 ou 7, dans laquelle la longueur des paires de bras courbes (34), en tenant compte d'une portion centrale (40), couvre angulairement un secteur de cercle compris entre 60° et 160°, notamment entre 80° et 140°.

11. Installation selon l'une quelconque des revendications 6 à 10, dans laquelle les extrémités (38) des bras (34) s'inscrivent dans une forme correspondant au tracé de la portion centrale (40).

12. Installation selon l'une quelconque des revendications 1 à 11, dans laquelle le support rotatif (26) possède une forme concave de sorte que les logements (28) d'articles optiques sont disposés à égale distance de la source émettrice (22).

## Patentansprüche

1. Anlage (20) zum Aufdampfen einer Beschichtung auf optische Artikel (10), umfassend
- eine Quelle (22), die Moleküle eines auf die optischen Artikel (10) aufzubringenden Materials emittiert, wobei die Moleküle entlang eines Verdampfungskegels emittiert werden,
- eine drehbare Halterung (26) für optische Artikel (10), die Einzelaufnahmen (28) umfasst, die dazu bestimmt sind, die optischen Artikel (10) aufzunehmen, und während des Drehens der drehbaren Halterung (26) Umdrehungen vollführt, wobei die Einzelaufnahmen (28) für optische Artikel (10) auf konzentrischen Bahnen (30) angeordnet sind, und
- eine Verteilungsblende (32), die auf dem Weg eines Teils der von der emittierenden Quelle (22) in Richtung der drehbaren Halterung (26) für optische Artikel (10) emittierten Moleküle angeordnet ist,
wobei die Verteilungsblende (32) mit mindestens einem gekrümmten Arm (34) gestaltet ist, der sich entlang einer zugeordneten Bahn (30) erstreckt und so angeordnet ist, dass er einen Teilbereich (16) einer Einzelaufnahme (28) über einen Teil der Umdrehung maskiert, wobei dieser maskierte Teilbereich (16) den Mittelpunkt der Einzelaufnahme (28) beinhaltet, wobei der mindestens eine gekrümmte Arm (34) zentriert gegenüber der konzentrischen Bahn (30) angeordnet ist und die Breite jedes gekrümmten Arms (34) senkrecht zu der zugeordneten Bahn (30) so ausgestaltet ist, dass die Projektion des gekrümmten Arms (34) auf die Einzelaufnahmen (28) der zugeordneten Bahn (30) eine Breite senkrecht zu der zugeordneten Bahn (30) besitzt, die geringer als die Breite der Einzelaufnahmen (28) ist.

2. Anlage nach Anspruch 1, wobei die Blende (32) einen Arm (34) für jede Bahn (30) der drehbaren Halterung (26) umfasst.

3. Anlage nach einem der Ansprüche 1 bis 2, wobei die Breite (L_{B}) senkrecht zu der zugeordneten Bahn (30) der Projektion des Arms (34) auf die optischen Artikel (10) der zugeordneten Bahn (30) zwischen 60 % und 95 %, insbesondere zwischen 80 % und 90 % und besonders bevorzugt 85 % der Breite der von der drehbaren Halterung (26) getragenen optischen Artikel (10) beträgt.

4. Anlage nach einem der Ansprüche 1 bis 3, wobei jeder Arm (34) ein gerundetes Ende (38) besitzt.

5. Anlage nach Anspruch 4, wobei der Krümmungsradius der gerundeten Enden (38) dem Krümmungsradius des optischen Artikels (10) entspricht, der die Beschichtung aufnehmen soll.

6. Anlage nach einem der Ansprüche 1 bis 5, wobei die Blende (32) einen zentralen Abschnitt (40) umfasst, der dazu ausgestaltet ist, eine Inhomogenität des Verdampfungskegels (24) zwischen den verschiedenen Bahnen (30) von Aufnahmen (28) optischer Artikel auszugleichen.

7. Anlage nach Anspruch 6, wobei sie für jede Bahn (30) von Aufnahmen (28) einen ersten und einen zweiten Arm (34) umfasst, die den zentralen Abschnitt (40) symmetrisch beidseits des zentralen Abschnitts (40) verlängern.

8. Anlage nach Anspruch 6 oder 7, wobei der zentrale Abschnitt (40) eine elliptische oder Trapezform aufweist.

9. Anlage nach einem der Ansprüche 1 bis 8, wobei die Länge der Arme (34) mit der Entfernung der konzentrischen zugeordneten Bahnen (30) von der Drehachse (A) der drehbaren Halterung (26) zunimmt.

10. Anlage nach Anspruch 6 oder 7, wobei die Länge der Paare gekrümmter Arme (34), unter Berücksichtigung eines zentralen Abschnitts (40), winkelmäßig einen Kreissektor zwischen 60° und 160°, insbesondere zwischen 80° und 140°, abdeckt.

11. Anlage nach einem der Ansprüche 6 bis 10, wobei die Enden (38) der Arme (34) in eine Form einbeschrieben sind, die dem Verlauf des zentralen Abschnitts (40) entspricht.

12. Anlage nach einem der Ansprüche 1 bis 11, wobei die drehbare Halterung (26) eine konkave Form besitzt, so dass die Aufnahmen (28) optischer Artikel abstandsgleich zu der emittierenden Quelle (22) angeordnet sind.

## Claims

1. Installation (20) for vapour deposition of a coating on optical articles (10), comprising
- a source (22) emitting molecules of a material to be deposited on the optical articles (10), the molecules being emitted according to an evaporation cone,
- a rotary support (26) of optical articles (10) comprising individual receptacles (28) intended to receive the optical articles (10) and performing revolutions while the rotary support (26) is rotating, the individual receptacles (28) of optical articles (10) being arranged in concentric tracks (30), and
- a distribution mask (32) arranged on the path of a portion of the molecules emitted by said emitting source (22) towards the rotary support (26) of optical articles (10),
wherein the distribution mask (32) is formed with at least one curved arm (34) extending along an associated track (30) and arranged so as to mask a partial zone (16) of an individual receptacle (28) over a part of the revolution, this masked partial zone (16) including the centre of the individual receptacle (28), the at least one curved arm (34) being arranged so as to be centred facing the concentric track (30), and the width of each curved arm (34) at right angles to the associated track (30) is configured such that the projected imprint of the curved arm (34) on the individual receptacles (28) of the associated track (30) has a width at right angles to the associated track (30) which is less than the width of the individual receptacles (28).

2. Installation according to Claim 1, wherein the mask (32) comprises an arm (34) for each track (30) of the rotary support (26).

3. Installation according to either one of Claims 1 and 2, wherein the width (L_{B}) at right angles to the associated track (30) of the projected imprint of the arm (34) on the optical articles (10) of the associated track (30) lies between 60% and 95%, notably between 80% and 90% and more particularly 85% of the width of the optical articles (10) borne by the rotary support (26) .

4. Installation according to any one of Claims 1 to 3, wherein each arm (34) has a rounded end (38).

5. Installation according to Claim 4, wherein the radius of curvature of the rounded ends (38) corresponds to the radius of curvature of the optical article (10) having to receive the coating.

6. Installation according to any one of Claims 1 to 5, wherein the mask (32) comprises a central portion (40) configured to compensate for a non-uniformity of the evaporation cone (24) between the different tracks (30) of receptacles (28) of optical articles.

7. Installation according to Claim 6, wherein it comprises, for each track (30) of receptacles (28), a first arm and a second arm (34) extending the central portion (40) symmetrically on either side of the central portion (40).

8. Installation according to Claim 6 or 7, wherein the central portion (40) has an elliptical or trapezoidal form.

9. Installation according to any one of Claims 1 to 8, wherein the length of the arms (34) increases with the distance of the concentric associated tracks (30) from the axis of rotation (A) of the rotary support (26) .

10. Installation according to Claim 6 or 7, wherein the length of the pairs of curved arms (34), taking into account a central portion (40), angularly masks a segment of a circle of between 60° and 160°, notably between 80° and 140°.

11. Installation according to any one of Claims 6 to 10, wherein the ends (38) of the arms (34) describe a form corresponding to the trace of the central portion (40) .

12. Installation according to any one of Claims 1 to 11, wherein the rotary support (26) has a concave form such that the receptacles (28) of optical articles are arranged equidistant from the emitting source (22).
